# EUROPEAN PATENT APPLICATION

(11) **EP 4 576 220 A1**
(43) Date of publication of application: **25.06.2025**
(21) Application number: 22961521.6
(22) Date of filing: 07.10.2022
(51) Int. Cl.: H01L 27/15, H01L 25/075, H01L 27/12, H01L 33/62, H01L 33/38, H01L 33/44, H01L 33/40

(54) **DISPLAY DEVICE**

(71) Applicant: LG Electronics Inc., Yeongdeungpo-gu Seoul 07336 (KR)
(72) Inventor: HEO, Mihee, Seoul 06772 (KR); HWANG, Sunghyun, Seoul 06772 (KR); KANG, Byungjun, Seoul 06772 (KR); PARK, Hyungjo, Seoul 06772 (KR)
(74) Representative: Vossius & Partner Patentanwälte Rechtsanwälte mbB
(86) International application number: PCT/KR2022/015191
(87) International publication number: WO 2024/075876

(57) **Abstract**

The display device may include a substrate, a first assembly wiring and a second assembly wiring on the substrate, a partition wall having an assembly hole on the first assembly wiring and the second assembly wiring, a semiconductor light-emitting element having a recess and seated on the protruding part, and a connecting electrode on a lower side of the semiconductor light-emitting element.

## Description

### [Technical Field]

The embodiment relates to a display device.

### [Background Art]

A large-area display include a liquid crystal display (LCD), an OLED display, and a micro-LED display.

A micro-LED display is a display that uses micro-LEDs, which are semiconductor light-emitting elements with a diameter or cross-sectional area of 100*µ*m or less, as display elements.

Since a micro-LED display uses micro-LEDs, which are semiconductor light-emitting elements, as display elements, it has excellent performance in many characteristics such as contrast ratio, response speed, color reproducibility, viewing angle, brightness, resolution, lifespan, luminescence efficiency, and luminance.

In particular, a micro-LED display has the advantage of being able to freely adjust the size or resolution because the screen may be separated and combined in a modular manner, and it has the advantage of being able to implement a flexible display.

However, since a large-area micro-LED display requires millions or more micro-LEDs, there is a technical problem that it is difficult to quickly and accurately transfer micro-LEDs to a display panel.

Recently developed transfer technologies include the pick and place process, the laser lift-off method, and the self-assembly method.

Among these, the self-assembly method is a method in which semiconductor light-emitting elements find their assembly positions in a fluid on their own, which is advantageous for implementing a large-screen display device.

However, research on the technology for manufacturing displays through self-assembly of micro-LEDs is still insufficient.

In particular, in a conventional technology, when rapidly transferring millions or more semiconductor light-emitting elements to a large display, the transfer speed can be improved, but the transfer error rate can increase, which causes a technical problem in that the transfer yield is low.

In the related technology, a self-assembly transfer process using dielectrophoresis (DEP) is being attempted, but there is a problem in that the self-assembly rate is low due to the unevenness of the DEP force.

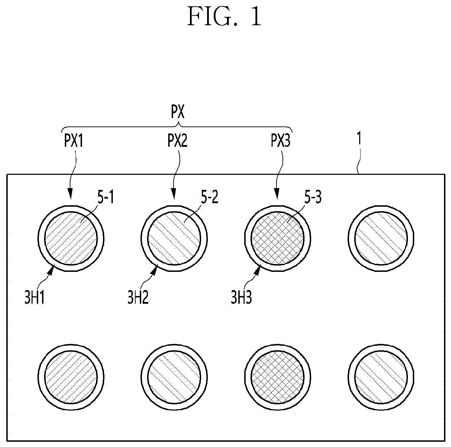

FIG. 1 is a plan view illustrating a general display device.

As illustrated in FIG. 1, semiconductor light-emitting elements 5-1, 5-2, and 5-3 may be disposed in assembly holes 3H1, 3H2, and 3H3 in subpixels PX1, PX2, and PX3 included in each pixel PX on the substrate 1. The plurality of semiconductor light-emitting elements 5-1, 5-2, and 5-3 emit light of different colors.

The semiconductor light-emitting elements 5-1, 5-2, and 5-3 are assembled in the corresponding assembly holes 3H1, 3H2, and 3H3, respectively, using a self-assembly method.

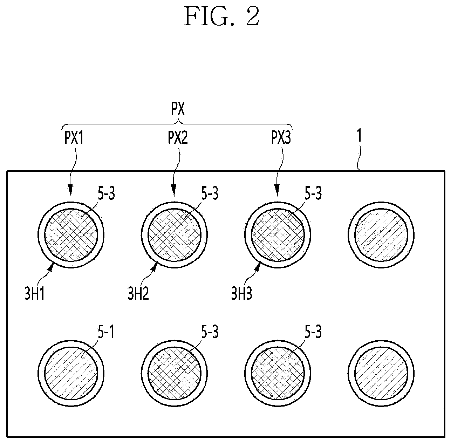

However, since the semiconductor light-emitting elements 5-1, 5-2, and 5-3 have the same shape, there was a problem of incorrect assembly occurring during self-assembly. That is, as illustrated in FIG. 2, the third semiconductor light-emitting element 5-3 is not assembled into the third assembly hole 3H3, but is assembled into the first assembly hole 3H1 or the second assembly hole 3H2, so that correct assembly does not occur. Such incorrect assembly causes color mixing defects. The color mixing defects means a defect in which a subpixel that should emit a preset color light emits a different color light, so that the preset color light is not emitted and the desired image is not implemented.

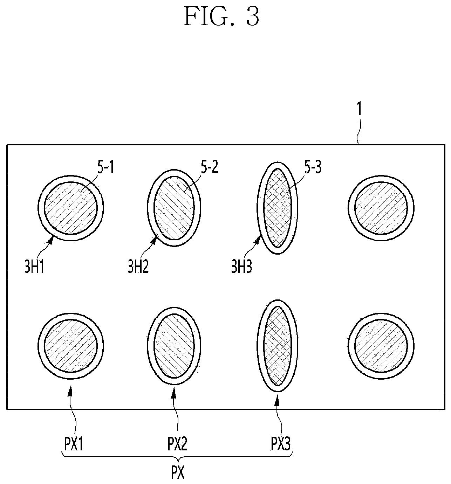

In order to solve this problem, as illustrated in FIG. 3, the exclusivity of different shapes was given to each of the plurality of semiconductor light-emitting elements 5-1, 5-2, and 5-3, thereby reducing the incorrect assembly rate.

However, there was still a problem in which incorrect assembly occurred.

In addition, there was a problem that the second semiconductor light-emitting element 5-2 and the third semiconductor light-emitting element 5-3, each of which has an oval shape, were slower to assemble than the first semiconductor light-emitting element 5-1, which has a circular shape, and the assembly rate decrease as the exclusivity is strengthened.

In addition, as the exclusivity is strengthened, the probability of detachment of the semiconductor light-emitting elements 5-1, 5-2, and 5-3 assembled in the corresponding assembly holes 3H1, 3H2, and 3H3 increase, resulting in an increase in assembly defects.

### [Disclosure]

### [Technical Problem]

An object of the embodiment is to solve the foregoing and other problems.

Another object of the embodiment is to provide a display device capable of improving electrical contact performance by changing the structure of a lower side of a semiconductor light-emitting element.

In addition, another object of the embodiment is to provide a display device capable of strengthening the fixing force of a semiconductor light-emitting element by changing the structure of a lower side of a semiconductor light-emitting element.

In addition, another object of the embodiment is to provide a display device capable of improving the assembly rate and luminance by making a plurality of semiconductor light-emitting elements that emit different color light have the same shape.

In addition, another object of the embodiment is to provide a display device capable of minimizing assembly defects by making a plurality of semiconductor light-emitting elements that emit different color light have the same shape.

The technical problems of the embodiments are not limited to those described in this item and include those that may be understood through the description of the invention.

### [Technical Solution]

In order to achieve the above or other objects, according to one aspect of the embodiment, a display device, comprising: a substrate; a first assembly wiring and a second assembly wiring on the substrate; a partition wall having an assembly hole on the first assembly wiring and the second assembly wiring; a protruding part in the assembly hole; a semiconductor light-emitting element having a recess and seated on the protruding part; and a connecting electrode on a lower side of the semiconductor light-emitting element.

The protruding part may be an insulating pattern. The protruding part may have a shape corresponding to a shape of the recess.

The protruding part may be a metal pattern. The protruding part may comprise a first protruding region and a second protruding region that are horizontally spaced from each other.

A thickness of the protruding part may be greater than a depth of the recess. The connecting electrode may be disposed in a gap region between the thickness of the protruding part and the depth of the recess.

The semiconductor light-emitting element may comprise a light-emitting layer; an electrode under the light-emitting layer; and a passivation layer configured to surround the light-emitting layer. A lower surface of the light-emitting layer may have a first region and a second region configured to surround the first region, and the recess may be formed in the first region of the light-emitting layer. The electrode may comprise a first metal layer on the lower surface of the light-emitting layer; a second metal layer under the first metal layer; and a third metal layer under the second metal layer, the first metal layer may be in contact with the first region of the light-emitting layer, and the second metal layer may be in contact with the second region of the light-emitting layer and the first metal layer.

An electrical resistance of the second metal layer may be smaller than an electrical resistance of the first metal layer.

The first metal layer may comprise a reflective layer, the second metal layer may comprise an ohmic contact layer, and the third metal layer may comprise a magnetic layer.

The substrate may comprise a plurality of pixels, each of the plurality of pixels may comprise a first subpixel, a second subpixel, and a third subpixel, the semiconductor light-emitting element may comprise a first semiconductor light-emitting element on the first subpixel, a second semiconductor light-emitting element on the second subpixel, and a third semiconductor light-emitting element on the third subpixel, and sizes of the first semiconductor light-emitting element, the second semiconductor light-emitting element, and the third semiconductor light-emitting element may be different.

The recess may have a first recess on a lower side of the first semiconductor light-emitting element, a second recess on a lower side of the second semiconductor light-emitting element, and a third recess on a lower side of the third semiconductor light-emitting element, and sizes of the first recess, the second recess, and the third recess may be different.

The protruding part may comprise a first protruding part in the first assembly hole on the first subpixel; a second protruding part in the second assembly hole on the second subpixel; and a third protruding part in the third assembly hole on the third subpixel, and sizes of the first protruding part, the second protruding part, and the third protruding part may be different.

The connecting electrode may comprise a first connecting electrode in a first gap region between a thickness of the first protruding part and a depth of the first recess; a second connecting electrode in a second gap region between a thickness of the second protruding part and a depth of the second recess; and a third connecting electrode in a third gap region between a thickness of the third protruding part and a depth of the third recess.

### [Advantageous Effects]

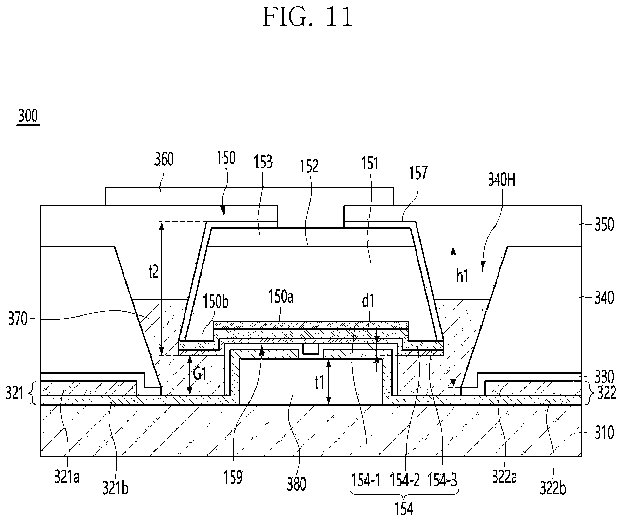

In the embodiment, as illustrated in FIG. 11, a protruding part 380 may be disposed in the assembly hole 340H, a recess 159 may be provided on the lower side of the semiconductor light-emitting element 150, and the protruding part 380 may be inserted into the recess 159 of the semiconductor light-emitting element 150, so that the fixing force of the semiconductor light-emitting element 150 can be strengthened, thereby preventing assembly defect.

In an embodiment, as illustrated in FIG. 11, a thickness t1 of the protruding part 380 may be made greater than a depth d1 of the recess 159, so that the connecting electrode 370 may be disposed in a gap region between the lower side of the semiconductor light-emitting element 150 and a first assembly wiring 321 and/or a second assembly wiring 322, thereby expanding the electrical contact area of the connecting electrode 370 for the semiconductor light-emitting element 150, so that the luminescence efficiency and the light luminance can be improved.

In the embodiment, as illustrated in FIG. 11, a part of the first assembly wiring 321 and a part of the second assembly wiring 322 may be disposed on the protruding part 380, so that the DEP force formed on the protruding part 380 may be greater than the DEP force on an edge region of the assembly hole 340H. Accordingly, the semiconductor light-emitting element 150 can be easily assembled into the assembly hole 340H during self-assembly by the DEP force formed to be greater on a center region of the assembly hole 340H, and the fixing force of the assembled semiconductor light-emitting element 150 can be strengthened. In addition, the semiconductor light-emitting element 150 can be reduced from falling out of the assembly hole 340H, thereby improving the lighting rate.

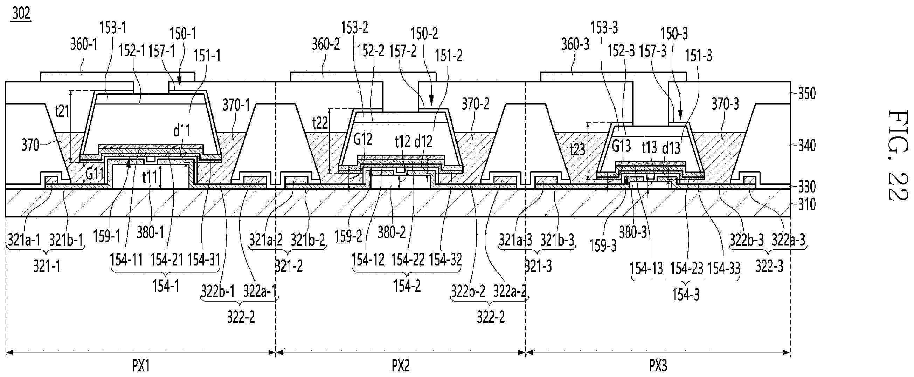

In the embodiment, as illustrated in FIG. 22, the widths or depths d11, d12, and d13 of the recesses of the semiconductor light-emitting elements 150-1, 150-2, and 150-3 on the first subpixel PX1, the second subpixel PX2, and the third subpixel XP3 may be made different to enhance exclusivity, so that the first semiconductor light-emitting element 150-1, the second semiconductor light-emitting element 150-2, and the third semiconductor light-emitting element 150-3 can be assembled simultaneously. Accordingly, the assembly speed can be drastically increased, so that productivity can be improved.

In the embodiment, as illustrated in FIG. 22, the widths or depths d11, d12, and d13 of the recesses of the semiconductor light-emitting elements 150-1, 150-2, and 150-3 on the first subpixel PX1, the second subpixel PX2, and the third subpixel XP3 may be made different to enhance exclusivity, so that incorrect assembly or color mixing defects can be prevented during self-assembly.

In the embodiment, as illustrated in FIG. 22, the first semiconductor light-emitting element 150-1, the second semiconductor light-emitting element 150-2, and the third semiconductor light-emitting element 150-3 may have the same shape, for example, a circular shape, while the widths or depths d11, d12, and d13 of the recesses are made different, so that the assembly rate and assembly speed can be improved. In addition, chip detachment can be minimized, so that assembly defects can be reduced, and thus the lighting rate can be improved.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view illustrating a general display device.
FIG. 2 illustrates a state in which color mixing defects occur during self-assembly in a general display device.
FIG. 3 is a plan view illustrating a display device according to a non-public internal technology.
FIG. 4 illustrates a living room of a house in which a display device according to an embodiment is disposed.
FIG. 5 is a block diagram schematically showing a display device according to an embodiment.
FIG. 6 is a circuit diagram showing an example of a pixel of FIG. 5.
FIG. 7 is an enlarged view of a first panel region in the display device of FIG. 4.
FIG. 8 is an enlarged view of a region A2 of FIG. 7.
FIG. 9 is a drawing illustrating an example of assembling a light-emitting element according to an embodiment to a substrate by a self-assembly method.
FIG. 10 is a plan view illustrating a display device according to a first embodiment.
FIG. 11 is a cross-sectional view illustrating a display device according to the first embodiment.
FIG. 12 is a cross-sectional view illustrating a backplane substrate according to an embodiment.
FIG. 13 is a plan view illustrating a semiconductor light-emitting element according to an embodiment.
FIG. 14 is a cross-sectional view illustrating a semiconductor light-emitting element according to an embodiment.
FIGS. 15 to 18 are drawings explaining a manufacturing process of a display device according to the first embodiment.
FIG. 19 is a plan view illustrating a display device according to a second embodiment.
FIG. 20 is a cross-sectional view illustrating a display device according to the second embodiment.
FIG. 21 is a plan view illustrating a display device according to a third embodiment.
FIG. 22 is a cross-sectional view illustrating a display device according to the third embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for a display, a display for VR, AR, or mixed reality (MR), a light source, etc. However, the configuration according to the embodiment described in this specification may be equally applied to a device capable of displaying, even if it is a new product type developed in the future.

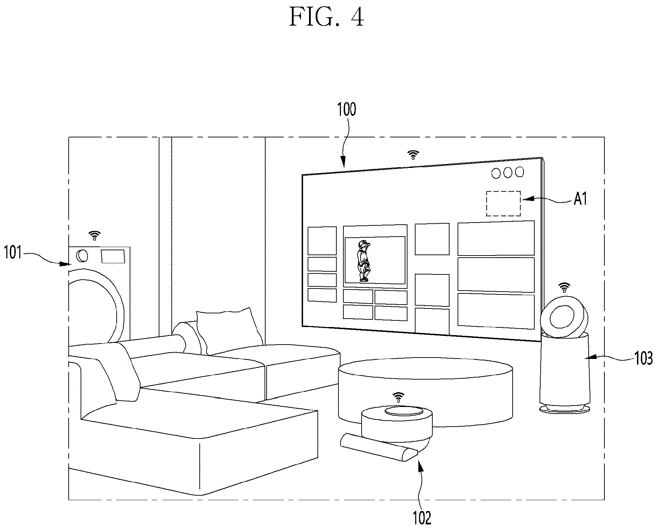

FIG. 4 illustrates a living room of a house in which a display device according to an embodiment is disposed.

Referring to FIG. 4, the display device 100 according to the embodiment may display the status of various electronic products such as a washing machine 101, a robot vacuum cleaner 102, and an air purifier 103, and may communicate with each electronic product based on IoT, and may also control each electronic product based on the user's setting data.

The display device 100 according to the embodiment may comprise a flexible display manufactured on a thin and flexible substrate. The flexible display may be bent or rolled like paper while maintaining the characteristics of a conventional flat display.

In the flexible display, visual information may be implemented by independently controlling the light emission of unit pixels disposed in a matrix form. A unit pixel means a minimum unit for implementing one color. The unit pixel of the flexible display may be implemented by a light-emitting element. In the embodiment, the light-emitting element may be a micro-LED or a nano-LED, but is not limited thereto.

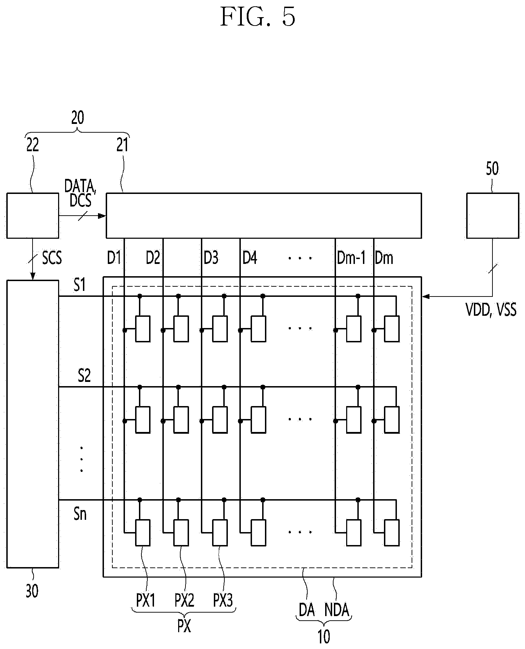

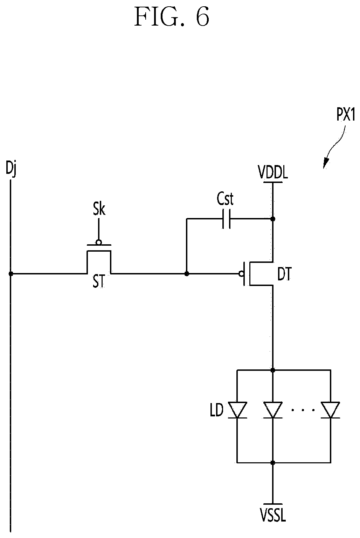

FIG. 5 is a block diagram schematically showing a display device according to an embodiment, and FIG. 6 is a circuit diagram showing an example of a pixel of FIG. 5.

Referring to FIG. 5 and FIG. 6, a display device according to an embodiment may comprise a display panel 10, a driving circuit 20, a scan driving unit 30, and a power supply circuit 50.

The display device 100 of the embodiment may drive a light-emitting element in an active matrix (AM) manner or a passive matrix (PM) manner.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on an upper surface of the substrate, and the non-display region NDA may be defined on a lower surface of the substrate. For example, the non-display region NDA may be defined on an entire region or a part of the lower surface of the substrate.

Meanwhile, although the drawing illustrates that the display region DA and the non-display region NDA are separated, the display region DA and the non-display region NDA may not be separated. That is, only the display region DA may exist on the upper surface of the substrate, and the non-display region NDA may not exist. In other words, an entire region of the upper surface of the substrate is the display region DA where the image is displayed, and a bezel area, which is the non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PXs connected to the data lines D1 to Dm and the scan lines S1 to Sn.

Each of the pixels PXs may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but is not limited thereto. In addition, FIG. 5 exemplifies that each of the pixels PX comprises three subpixels, but is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD, a plurality of transistors for supplying current to the light-emitting elements LD, and at least one capacitor Cst, as illustrated in FIG. 6.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 6. The driving transistor DT may comprise a gate electrode connected to a source electrode of the scan transistor ST, a source electrode connected to a high-potential voltage line VDDL to which a high-potential voltage VDD is applied, and a drain electrode connected to the first electrodes of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst is formed between the gate electrode and the source electrode of the driving transistor DT. The storage capacitor Cst charges a difference value between the gate voltage and the source voltage of the driving transistor DT.

The driving transistor DT and the scan transistor ST may be formed as thin film transistors. In addition, in FIG. 6, the driving transistor DT and the scan transistor ST are described as being formed as P-type metal oxide semiconductor field effect transistors (MOSFETs), but the present invention is not limited thereto. The driving transistor DT and the scan transistor ST may also be formed as N-type MOSFETs. In this instance, the positions of the source electrode and the drain electrode of each of the driving transistor DT and the scan transistor STs may be changed.

In addition, in FIG. 6, the first subpixel PX1, the second subpixel PX2, and the third subpixel PX3 are exemplified as comprising 2T1C (2 Transistor - 1 capacitor) having one driving transistor DT, one scan transistor ST, and one capacitor Cst, but the present invention is not limited thereto. The first subpixel PX1, the second subpixel PX2, and the third subpixel PX3 may each comprise a plurality of scan transistors ST and a plurality of capacitors Cst.

The second subpixel PX2 and the third subpixel PX3 may be expressed by substantially the same circuit diagram as the first subpixel PX1, so that detailed descriptions thereof are omitted.

The driving circuit 20 outputs signals and voltages for driving the display panel 10. To this end, the driving circuit 20 may comprise a data driving unit 21 and a timing control unit 22.

The data driving unit 21 receives digital video data and a source control signal DCS from the timing control unit 22. The data driving unit 21 converts digital video data into analog data voltages according to the source control signal DCS and supplies the converted data to data lines D1 to Dm of the display panel 10.

The timing control unit 22 receives digital video data and timing signals from a host system. The host system may be an application processor of a smartphone or tablet PC, a monitor, a system-on-chip of a TV, etc.

The timing control unit 22 generates control signals for controlling an operation timing of the data driving unit 21 and the scan driving unit 30. The control signals may comprise a source control signal DCS for controlling an operation timing of the data driving unit 21 and a scan control signal SCS for controlling an operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on a circuit board.

The scan driving unit 30 receives a scan control signal SCS from the timing control unit 22. The scan driving unit 30 generates scan signals according to the scan control signal SCS and supplies them to the scan lines S1 to Sn of the display panel 10. The scan driving unit 30 may be formed in a non-display region NDA of the display panel 10 and may comprise a plurality of transistors. Alternatively, the scan driving unit 30 may be formed as an integrated circuit, in which case it may be mounted on a gate flexible film attached to the other side of the display panel 10.

The power supply circuit 50 may generate voltages necessary for driving the display panel 10 from a main power applied from a system board and supply them to the display panel 10. For example, the power supply circuit 50 may generate a high-potential voltage VDD and a low-potential voltage VSS for driving the light-emitting elements LD of the display panel 10 from the main power supply and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power supply.

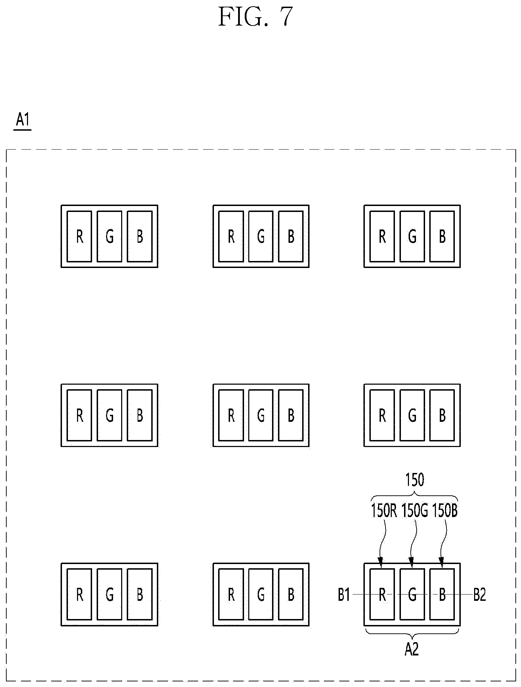

FIG. 7 is an enlarged view of the first panel region in the display device of FIG. 3.

Referring to FIG. 7, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 5).

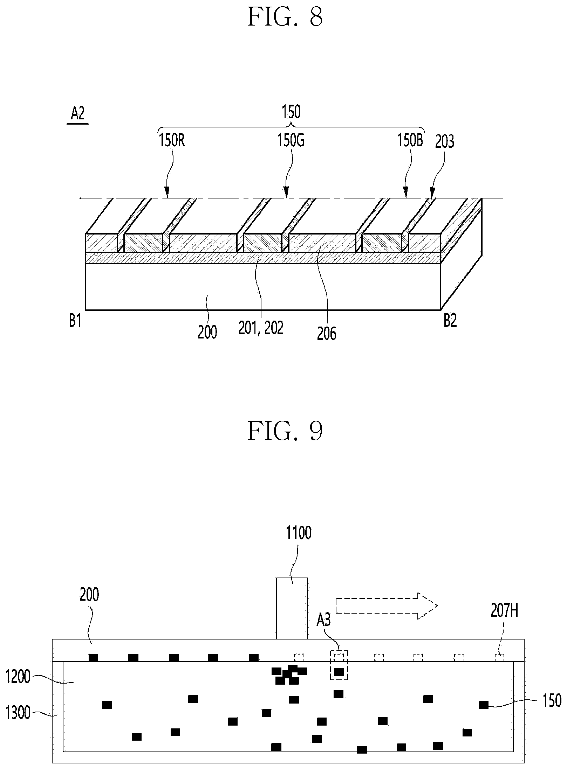

FIG. 8 is an enlarged view of a region A2 of FIG. 7.

Referring to FIG. 8, the display device 100 of the embodiment may comprise a substrate 200, assembly wirings 201 and 202, an insulating layer 206, and a plurality of semiconductor light-emitting elements 150. More components may be included than these.

The assembly wiring may comprise a first assembly wiring 201 and a second assembly wiring 202 that are spaced apart from each other. The first assembly wiring 201 and the second assembly wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flip-chip type semiconductor light-emitting element, and a vertical-type semiconductor light-emitting element.

The semiconductor light-emitting element 150 may comprise, but is not limited to, a red semiconductor light-emitting element 150R, a green semiconductor light-emitting element 150G, and a blue semiconductor light-emitting element 150B to form a unit pixel (subpixel), and may also comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a support substrate in the display panel, and may also function as an assembly substrate when self-assembling the light-emitting element.

The substrate 200 may be a backplane equipped with circuits, such as transistors ST and DT, capacitors Cst, and signal wiring, within each of the subpixels PX1, PX2, and PX3 illustrated in FIGS. 5 and 6, but is not limited thereto.

The insulating layer 206 may comprise an organic material having insulation and flexibility, such as polyimide, PAC, PEN, PET, polymer, or an inorganic material, such as silicon oxide (SiO₂) or silicon nitride series (SiNx), and may be formed integrally with the substrate 200 to form a single substrate.

The insulating layer 206 may be a conductive adhesive layer having adhesiveness and conductivity, and the conductive adhesive layer may have flexibility to enable a flexible function of the display device. For example, the insulating layer 206 may be an anisotropic conductive film (ACF) or a conductive adhesive layer such as an anisotropic conductive medium, a solution containing conductive particles, etc. The conductive adhesive layer may be a layer that is electrically conductive in a direction perpendicular to the thickness, but electrically insulating in a direction horizontal to the thickness.

The insulating layer 206 may comprise an assembly hole 203 for inserting the semiconductor light-emitting element 150. Accordingly, during self-assembly, the semiconductor light-emitting element 150 can be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may be different depending on the shape of the semiconductor light-emitting element 150. For example, the red semiconductor light-emitting element, the green semiconductor light-emitting element, and the blue semiconductor light-emitting element each have different shapes, and the assembly hole 203 having a shape corresponding to the shape of each of these semiconductor light-emitting elements may be provided. For example, the assembly hole 203 may comprise a first assembly hole for assembling a red semiconductor light-emitting element, a second assembly hole for assembling a green semiconductor light-emitting element, and a third assembly hole for assembling a blue semiconductor light-emitting element. For example, the red semiconductor light-emitting element may have a circular shape, the green semiconductor light-emitting element may have a first oval shape having a first minor axis and a first major axis, and the blue semiconductor light-emitting element may have a second oval shape having a second minor axis and a second major axis, but is not limited thereto. The second major axis of the oval shape of the blue semiconductor light-emitting element may be larger than the first major axis of the oval shape of the green semiconductor light-emitting element, and the second minor axis of the oval shape of the blue semiconductor light-emitting element may be smaller than the first minor axis of the oval shape of the green semiconductor light-emitting element.

Meanwhile, the method of mounting the semiconductor light-emitting element 150 on the substrate 200 may comprise, for example, a self-assembly method (FIG. 9) and a transfer method.

FIG. 9 is a drawing illustrating an example of assembling a light-emitting element according to an embodiment to a substrate by a self-assembly method.

Based on FIG. 9, an example of assembling a semiconductor light-emitting element according to an embodiment into a display panel by a self-assembly method using an electromagnetic field will be described.

The assembly substrate 200 described below may also function as a panel substrate in a display device after assembling the light-emitting element, but the embodiment is not limited thereto.

Referring to FIG. 9, the semiconductor light-emitting element 150 may be put into in a chamber 1300 filled with a fluid 1200, and the semiconductor light-emitting element 150 may be moved to the assembly substrate 200 by a magnetic field generated from the assembly device 1100. At this time, the semiconductor light-emitting element 150 adjacent to the assembly hole 207H of the assembly substrate 200 may be assembled into the assembly hole 207H by the DEP force caused by the electric field of the assembly wirings. The fluid 1200 may be water such as ultrapure water, but is not limited thereto. The chamber may be called a tank, a container, a vessel, etc.

After the semiconductor light-emitting element 150 is put into the chamber 1300, the assembly substrate 200 may be disposed on the chamber 1300. According to an embodiment, the assembly substrate 200 may be put into the chamber 1300.

The semiconductor light-emitting element 150 may be implemented as a vertical-type semiconductor light-emitting element as illustrated, but is not limited thereto, and a lateral-type light-emitting element may be employed.

The semiconductor light-emitting element 150 may comprise a magnetic layer (not illustrated) having a magnetic substance. The magnetic layer may comprise a metal having magnetism, such as nickel (Ni). Since the semiconductor light-emitting element 150 put into the fluid comprises the magnetic layer, it may move to the assembly substrate 200 by a magnetic field generated from the assembly device 1100. The magnetic layer may be disposed on the upper side, the lower side or both sides of the light-emitting device.

Meanwhile, the first assembly wiring 201 and the second assembly wiring 202 form an electric field as an AC voltage is applied, and the semiconductor light-emitting element 150 inserted into the assembly hole 207H may be fixed by the DEP force due to the electric field. A gap between the first assembly wiring 201 and the second assembly wiring 202 may be smaller than a width of the semiconductor light-emitting element 150 and a width of the assembly hole 207H, and the assembly position of the semiconductor light-emitting element 150 can be fixed more precisely using the electric field.

An insulating layer 215 is formed on the first assembly wiring 201 and the second assembly wiring 202 to protect the first assembly wiring 201 and the second assembly wiring 202 from the fluid 1200 and prevent leakage of current flowing in the first assembly wiring 201 and the second assembly wiring 202. For example, the insulating layer 215 may be formed of a single layer or multiple layers of an inorganic insulator such as silica or alumina, or an organic insulator. The insulating layer 215 may have a minimum thickness to prevent damage to the first assembly wiring 201 and the second assembly wiring 202 during assembly of the semiconductor light-emitting element 150, and may have a maximum thickness to stably assemble the semiconductor light-emitting element 150.

A partition wall 207 may be formed on an upper part of the insulating layer 215. A part of the partition wall 207 may be positioned on an upper part of the first assembly wiring 201 and the second assembly wiring 202, and the remaining region may be positioned on an upper part of the assembly substrate 200.

Meanwhile, when manufacturing the assembly substrate 200, a part of the partition wall formed on the upper part of the insulating layer 215 may be removed, thereby forming an assembly hole 207H in which each of the semiconductor light-emitting devices 150 is coupled and assembled to the assembly substrate 200.

An assembly hole 207H is formed in the assembly substrate 200, into which semiconductor light-emitting elements 150 are combined, and a surface on which the assembly hole 207H is formed may be in contact with a fluid 1200. The assembly hole 207H can guide an accurate assembly position of the semiconductor light-emitting element 150.

Meanwhile, the assembly hole 207H may have a shape and size corresponding to the shape of the semiconductor light-emitting element 150 to be assembled at a corresponding position. Accordingly, another semiconductor light-emitting element may be assembled in the assembly hole 207H or a plurality of semiconductor light-emitting elements can be prevented from being assembled.

Referring again to FIG. 9, after the assembly substrate 200 is disposed in the chamber, an assembly device 1100 that applies a magnetic field may move along the assembly substrate 200. The assembly device 1100 may be a permanent magnet or an electromagnet.

The assembly device 1100 may move in contact with the assembly substrate 200 to maximize a region affected by the magnetic field within the fluid 1200. Depending on the embodiment, the assembly device 1100 may comprise a plurality of magnetic substances or may comprise a magnetic substance of a size corresponding to the assembly substrate 200. In this instance, the movement distance of the assembly device 1100 may be limited within a predetermined range.

The semiconductor light-emitting element 150 within the chamber 1300 may move toward the assembly device 1100 and the assembly substrate 200 by the magnetic field generated by the assembly device 1100.

The semiconductor light-emitting element 150 may enter the assembly hole 207H and be fixed by the DEP force formed by the electric field between the assembly wirings 201 and 202 while moving toward the assembly device 1100.

Specifically, the first and second assembly wirings 201 and 202 form an electric field by an AC power source, and a DEP force may be formed between the assembly wirings 201 and 202 by the electric field. The semiconductor light-emitting element 150 may be fixed to the assembly hole 207H on the assembly substrate 200 by the DEP force.

At this time, a predetermined solder layer (not illustrated) is formed between the semiconductor light-emitting element 150 assembled on the assembly hole 207H of the assembly substrate 200 and the assembly wirings 201 and 202, thereby improving the binding strength of the semiconductor light-emitting element 150.

In addition, a molding layer (not illustrated) may be formed on the assembly hole 207H of the assembly substrate 200 after assembly. The molding layer may be a transparent resin or a resin containing a reflective material or a scattering material.

Since the time required for each semiconductor light-emitting element to be assembled on a substrate may be drastically shortened by the self-assembly method using the electromagnetic field described above, a large-area, high-pixel display can be implemented more quickly and economically.

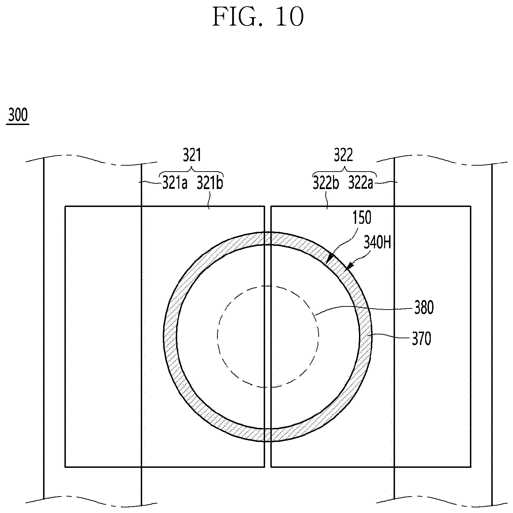

Hereinafter, various embodiments for solving the above-described problem will be described with reference to FIGS. 10 to 22. Any description omitted below may be easily understood from the description described above with respect to FIGS. 1 to 9 and the corresponding drawings.

### [First Embodiment]

FIG. 10 is a plan view illustrating a display device according to a first embodiment. FIG. 11 is a cross-sectional view illustrating a display device according to the first embodiment.

FIG. 10 and FIG. 11 illustrate one of a plurality of subpixels PX1, PX2, and PX3 included in each of the plurality of pixels PX defined in the display device 300 according to the first embodiment, and the structure of the remaining subpixels may also be the same as FIG. 10 and FIG. 11.

Referring to FIG. 10 and FIG. 11, the display device 300 according to the first embodiment may comprise a substrate 310, a first assembly wiring 321, a second assembly wiring 322, a partition wall 340, a protruding part 380, a first insulating layer 330, a semiconductor light-emitting element 150, and a connecting electrode 370.

The substrate 310 may be a supporting member that supports components disposed on the substrate 310 or a protective member that protects the components.

The first assembly wiring 321 may be disposed on the substrate 310. The second assembly wiring 322 may be disposed on the substrate 310.

For example, the first assembly wiring 321 and the second assembly wiring 322 may be disposed on the same layer, respectively. For example, the first and second assembly wirings 321 and 322 may be in contact with an upper surface of the substrate 310, but is not limited thereto. For example, the first assembly wiring 321 and the second assembly wiring 322 may be disposed on the same layer, respectively. For example, the first assembly wiring 321 and the second assembly wiring 322 may be disposed parallel to each other, respectively. The first assembly wiring 321 and the second assembly wiring 322 may each play a role in assembling the semiconductor light-emitting element 150 into an assembly hole 340H in a self-assembly manner. That is, an electric field may be generated between the first assembly wiring 321 and the second assembly wiring 322 by a voltage supplied to the first assembly wiring 321 and the second assembly wiring 322 during self-assembly, and the semiconductor light-emitting element 150 moving by the assembly device (1100 of FIG. 10) may be assembled into the assembly hole 340H by a DEP force formed by the electric field. The assembly hole 340H may have a diameter greater than the diameter of the semiconductor light-emitting element 150.

The first assembly wiring 321 and the second assembly wiring 322 may each comprise a plurality of metal layers. For example, the first assembly wiring 321 and the second assembly wiring 322 may comprise main wirings 321a and 322a and auxiliary electrodes 321b and 322b.

The first assembly wiring 321 may comprise a first main wiring 321a that is disposed elongated along a second direction (y direction) and a first auxiliary electrode 321b that extends from the first main wiring 321a toward the assembly hole 340H along a first direction (x direction). The second assembly wiring 322 may comprise a second main wiring 322a that is disposed elongated along the second direction (y direction) and a second auxiliary electrode 322b that extends from the second main wiring 322a toward the assembly hole 340H along the first direction (x direction). The first main wiring 321a and the second main wiring 322a may be disposed parallel along the second direction, and the first auxiliary electrode 321b and the second auxiliary electrode 322b may be disposed to face each other within the assembly hole 340H. The first auxiliary electrode 321b and the second auxiliary electrode 322b may be spaced apart from each other along the first direction.

Since the main wirings 321a and 322a need to be as long as an entire length of the display panel, they may be formed of a metal having excellent electrical conductivity in order to minimize voltage drop due to internal resistance. The auxiliary electrodes 321b and 322b may form a DEP force during self-assembly or emit light from the semiconductor light-emitting element 150 during driving by using an electrical signal supplied to the main wirings 321a and 322a. The auxiliary electrodes 321b and 322b are very small compared to the length of the main wirings 321a and 322a as a length from the main wirings 321a and 322a to a predetermined point within the assembly hole 340H, so that the electrical conductivity may be smaller than that of the main wirings 321a and 322a, but is not limited thereto.

Although not illustrated, the first assembly wiring 321 and the second assembly wiring 322 may be disposed on different layers.

The partition wall 340 may be disposed on the first assembly wiring 321 and the second assembly wiring 322. The partition wall 340 may have an assembly hole 340H for assembling the semiconductor light-emitting element 150. For example, the first insulating layer 330 may be exposed within the assembly hole 340H. For example, a bottom surface of the assembly hole 340H may be an upper surface of the first insulating layer 330.

A height h1 (or thickness) of the partition wall 340 may be determined in consideration of a thickness t2 of the semiconductor light-emitting element 150. For example, the thickness h1 of the partition wall 340 may be smaller than the thickness t2 of the semiconductor light-emitting element 150. Accordingly, an upper side of the semiconductor light-emitting element 150 may be positioned higher than an upper surface of the partition wall 340. That is, an upper side of the semiconductor light-emitting element 150 may protrude from the upper surface of the partition wall 340 toward an upper direction.

A size of the assembly hole 340H may be determined by considering a tolerance margin, etc., to facilitate the assembly of the semiconductor light-emitting element 150. For example, the size of the assembly hole 340H may be greater than a size of the semiconductor light-emitting element 150. For example, when the semiconductor light-emitting element 150 is assembled at the center of the assembly hole 340H, a distance between an outer side of the semiconductor light-emitting element 150 and an inner side of the assembly hole 340H may be 2*µ*m or less, but is not limited thereto. For example, when the semiconductor light-emitting element 150 is assembled at the center of the assembly hole 340H, the distance between the outer side of the semiconductor light-emitting element 150 and the inner side of the assembly hole 340H may be 1.5*µ*m or less.

For example, the assembly hole 340H may have a shape corresponding to the shape of the semiconductor light-emitting element 150. For example, when the semiconductor light-emitting element 150 is circular, the assembly hole 340H may also be circular. For example, when the semiconductor light-emitting element 150 is rectangular, the assembly hole 340H may also be rectangular.

A protruding part 380 may be disposed in the assembly hole 340H. The protruding part 380 may protrude toward an upper direction within the assembly hole 340H.

For example, the protruding part 380 may be disposed between the substrate 310 and the first insulating layer 330. For example, the protruding part 380 may be disposed between the substrate 310 and the first insulating layer 330 within the assembly hole 340H. For example, one side of the protruding part 380 may be in contact with the first assembly wiring 321, and the other side of the protruding part 380 may be in contact with the second assembly wiring 322. For example, one side of the protruding part 380 may be in contact with the first auxiliary electrode 321b of the first assembly wiring 321, and the other side of the protruding part 380 may be in contact with the second auxiliary electrode 322b of the second assembly wiring 322. For example, a part of the first auxiliary electrode 321b of the first assembly wiring 321 may be in contact with one side of the protruding part 380, and a part of the second auxiliary electrode 322b of the second assembly wiring 322 may be in contact with the other side of the protruding part 380. For example, a part of the first auxiliary electrode 321b of the first assembly wiring 321 may vertically overlap a part of an upper surface of the protruding part 380. For example, a part of the second auxiliary electrode 322b of the second assembly wiring 322 may vertically overlap the other part of the upper surface of the protruding part 380.

When the semiconductor light-emitting element 150 is circular, the recess 159 may be circular. In this instance, the protruding part 380 may also have a circular shape to correspond to the recess 159.

When the protruding part 380 is circular, the first auxiliary electrode 321b of the first assembly wiring 321 may wrap around a first round side and an upper surface of the protruding part 380, and the second extended electrode of the second assembly wiring 322 may wrap around a second round side and an upper surface of the protruding part 380. The first round side and the second round side may face each other and may be symmetrical with respect to the center of the protruding part 380. The first auxiliary electrode 321b of the first assembly wiring 321 and the second auxiliary electrode 322b of the second assembly wiring 322 may be spaced apart from each other on the lateral surface and/or upper surface of the protruding part 380. A first insulating layer 330 may be disposed between the first auxiliary electrode 321b of the first assembly wiring 321 and the second auxiliary electrode 322b of the second assembly wiring 322 on the lateral surface and/or upper surface of the protruding part 380, so that an electrical short between the first auxiliary electrode 321b of the first assembly wiring 321 and the second auxiliary electrode 322b of the second assembly wiring 322 can be prevented by the first insulating layer 330.

A thickness t1 of the protruding part 380 may be greater than a depth d1 of the recess 159 of the semiconductor light-emitting element 150. In this instance, when the semiconductor light-emitting element 150 is seated on the protruding part 380 and the protruding part 380 is inserted into the recess 159 of the semiconductor light-emitting element 150, a predetermined gap G1 may be formed between a lower surface of the semiconductor light-emitting element 150 and the first auxiliary electrode 321b of the first assembly wiring 321 and/or the second auxiliary electrode 322b of the second assembly wiring 322. The gap G1 may be referred to as a separation distance. The gap G1 is a separation distance between the thickness t1 of the protruding part 380 and the depth d1 of the recess 159, and a space having the gap G1 may be defined as a gap region.

As will be described later, by disposing the connecting electrode 370 in the gap G1, an electrical contact area between the connecting electrode 370 and the electrode 154 of the semiconductor light-emitting element 150 can be expanded, thereby increasing the luminance.

The protruding part 380 may be an insulating pattern. That is, the protruding part 380 may be formed in the assembly hole 340H by patterning after an insulating film forming an insulator is formed on the substrate 310. The protruding part 380 may be formed in an isolated island shape on each of the subpixels PX1, PX2, and PX3. That is, the protruding part 380 of each subpixel may be separated from each other.

An organic material that is easy to form a thickness may be used as the insulator, but is not limited thereto. For example, the protruding part 380 may be formed of a photosensitive material. After a photosensitive film made of a photosensitive material is applied, the protruding part 380 may be formed in the assembly hole 340H by using an exposure process and a development process.

Since the protruding part 380 is an insulating pattern, even if the first assembly wiring 321 and the second assembly wiring 322 come into contact with the protruding part 380, an electrical short between the first assembly wiring 321 and the second assembly wiring 322 can be prevented by the protruding part 380.

Since the protruding part 380 has a shape corresponding to the lower side of the semiconductor light-emitting element 150 assembled in the assembly hole 340H, i.e., the recess 159, an upper side of the protruding part 380 may be inserted into the recess 159 of the semiconductor light-emitting element 150.

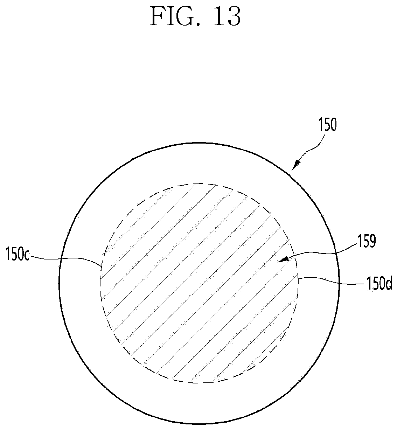

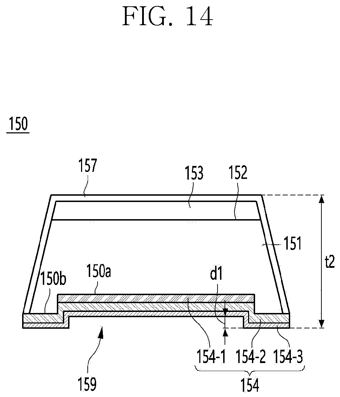

As illustrated in FIGS. 13 and 14, the semiconductor light-emitting element 150 may comprise a light-emitting part 151, 152, and 153, an electrode 154, and a passivation layer 157. The semiconductor light-emitting element 150 may comprise more components than these.

The light-emitting part 151, 152, and 153 comprise a first conductivity type semiconductor layer 151, an active layer 152, and a second conductivity type semiconductor layer 153, but may comprise more components. The first conductivity type semiconductor layer 151 may comprise a first conductive dopant, and the second conductivity type semiconductor layer 153 may comprise a second conductive dopant. For example, the first conductive dopant may be an n-type dopant, such as silicon (Si), and the second conductive dopant may be a p-type dopant, such as boron (B).

Although not illustrated, a second electrode may be disposed on the second conductivity type semiconductor layer 153. The second electrode may comprise at least one or more layer. The second electrode may comprise a transparent conductive layer and a magnetic layer. The transparent conductive layer may be made of a transparent conductive material, for example, ITO. The transparent conductive layer may obtain a current spreading effect that allows current supplied from the electrode wiring 360 to evenly spread throughout an entire region of the second conductivity type semiconductor layer 153. That is, current may be evenly spread across an entire region of the second conductive semiconductor layer 153 by the transparent conductive layer, and holes are generated across the entire region of the second conductive semiconductor layer 153. Accordingly, the amount of light generated by the recombination of holes and electrons in the active layer 152 may increase due to the increase in the amount of hole generation, thereby increasing the light efficiency. An increase in light efficiency can lead to an improvement in luminance.

In the embodiment, the recess 159 may be formed on a lower side of the light-emitting part 151, 152, and 153. Specifically, the recess 159 may be formed on a lower surface of the first conductivity type semiconductor layer 151. At this time, even if the electrode 154 is formed on the lower side of the light-emitting part 151, 152 and 153, the depth d1 of the recess 159 formed on the lower side of the light-emitting part 151, 152 and 153 can be considered so that the same recess 159 may be formed on the second electrode 154 as well.

A lower surface of the light-emitting part 151, 152 and 153 may comprise a first light-emitting region 150a and a second light-emitting region 150b surrounding the first light-emitting region 150a. In this instance, the recess 159 may be formed in the first light-emitting region 150a of the light-emitting part 151, 152 and 153.

That is, first, the light-emitting part 151, 152, and 153 may be deposited on a sapphire substrate using a deposition process, and then an etching process may be performed to form the light-emitting part 151, 152, and 153 in a chip unit. Thereafter, after the passivation layer 157 is deposited, a temporary substrate may be adhered to the light-emitting part 151, 152, and 153. Thereafter, the sapphire substrate may be removed using an LLO process. At this time, an undoped semiconductor layer on the sapphire substrate may also be removed, but is not limited thereto. Thereafter, an etching process may be performed on the first light-emitting region 150a of the light-emitting part 151, 152, and 153, so that a recess 159 having a predetermined depth d1 may be formed. Thereafter, after the electrode 154 is formed on the lower side of the light-emitting part 151, 152, and 153, the temporary substrate may be removed, so that a large number of semiconductor light-emitting devices 150 may be manufactured at a wafer level.

The passivation layer 157 may protect the light-emitting part 151, 152, and 153.

The passivation layer 157 may prevent the semiconductor light-emitting element 150 from being flipped over during self-assembly, and a lower side of the semiconductor light-emitting element 150, that is, a lower surface of the first conductivity type semiconductor layer 151, may face the upper surface of the first insulating layer 330. Therefore, during self-assembly, the lower side of the semiconductor light-emitting element 150 may be positioned facing the first insulating layer 330, and the upper side of the semiconductor light-emitting element 150 may be positioned toward an upper direction, so that misalignment in which the semiconductor light-emitting element 150 is flipped over and assembled can be prevented.

The electrode 154 may be disposed on the lower side of the first conductivity type semiconductor layer 151. The electrode 154 may comprise at least one or more layer.

In an embodiment, the electrode 154 may comprise a first metal layer 154-1, a second metal layer 154-2, and a third metal layer 154-3.

The first metal layer 154-1 may be disposed on a lower surface of the light-emitting part 151, 152, and 153, the second metal layer 154-2 may be disposed under the first metal layer 154-1, and the third metal layer 154-3 may be disposed under the second metal layer 154-2.

For example, the first metal layer 154-1 may be disposed within the recess 159. To this end, a predetermined metal film may be formed and patterned under the light-emitting part 151, 152, and 153, so that the first metal layer 154-1 may be formed only within the recess 159. The first metal layer 154-1 may comprise a reflective layer, such as aluminum (Al). The first metal layer 154-1 can improve luminance by increasing luminescence efficiency by reflecting color light generated from the semiconductor light-emitting element 150 forward. Since the first metal layer 154-1 may have a reflective function, it may have a thin thickness of 100 nm or less. When the first metal layer 154-1 is formed thicker than 100 nm, the recess 159 formed in a lower side of the light-emitting part 151, 152, and 153 by the electrode 154 may disappear.

For example, the second metal layer 154-2 may be disposed under the first metal layer 154-1, and may be disposed not only on the first light-emitting region 150a of the light-emitting part 151, 152, and 153, but also on the second light-emitting region 150b. The second metal layer 154-2 may comprise an ohmic contact layer. The ohmic contact layer may play a role in lowering a driving voltage by improving the ohmic contact with the light-emitting part 151, 152, and 153 made of a semiconductor material.

A part of the second metal layer 154-2 may be in contact with the first metal layer 154-1, and the other part of the second metal layer 154-2 may be in contact with the second light-emitting region 150b of the light-emitting part 151, 152, and 153. An electrical resistance of the second metal layer 154-2 may be smaller than an electrical resistance of the first metal layer 154-1. In this instance, the current on the light-emitting part 151, 152, and 153 may flow outward through the second metal layer 154-2 in contact with the second light-emitting region 150b of the light-emitting part 151, 152, and 153 rather than through the first metal layer 154-1. Accordingly, the current on the light-emitting part 151, 152, and 153 may not flow concentratedly in the vertical direction but may flow to an edge region of the light-emitting part 151, 152, and 153, so that the light-generating area or light-emitting area of the light-emitting part 151, 152, and 153, particularly the active layer 152 can be expanded, thereby improving the light luminance.

Meanwhile, the third metal layer 154-3 may be disposed under the second metal layer 154-2. The third metal layer 154-3 may comprise a magnetic layer such as nickel (Ni) or cobalt (Co). The second metal layer 154-2 may be disposed on an entire region of the lower surface of the light-emitting part 151, 152, and 153. In this way, as an area of the third metal layer 154-3 having a magnetic function may be expanded, the magnetization force can be increased. When self-assembling, the third metal layer 154-3 of the semiconductor light-emitting element 150 may be magnetized by the magnet and may immediately accompany the movement of the magnet, so that the third metal layer 154-3 of the electrode 154 can improve the movement speed of the semiconductor light-emitting element 150 during self-assembly, thereby contributing to improving the assembly rate.

Although not illustrated, the second metal layer 154-2 and the third metal layer 154-3 may be disposed not only on a lower surface but also on a lateral surface of the light-emitting part 151, 152, and 153. In this instance, the light-generating area or the light-emitting area of the light-emitting part 151, 152, and 153 can be further expanded by the second metal layer 154-2, thereby further improving the light luminance, and since the magnetizing force can be further increased by the third metal layer 154-3, the moving speed of the semiconductor light-emitting element 150 can further increase during self-assembly, thereby improving the assembly rate.

Referring again to FIGS. 10 and 11, the connecting electrode 370 may be disposed in the assembly hole 340H. The connecting electrode 370 may electrically connect the semiconductor light-emitting element 150 and the first assembly wiring 321 and/or the second assembly wiring 322. For example, the connecting electrode 370 may electrically connect the electrode 154 of the semiconductor light-emitting element 150 and the first assembly wiring 321 and/or the second assembly wiring 322.

Since the connecting electrode 370 is disposed along the perimeter of the semiconductor light-emitting element 150 in the assembly hole 340H, the electrical contact area between the connecting electrode 370 and the semiconductor light-emitting element 150 can be greatly expanded, so that the luminescence efficiency and the light luminance can be improved.

As described above, when the semiconductor light-emitting element 150 is assembled in the assembly hole 340H and the protruding part 380 is inserted into the recess 159 of the semiconductor light-emitting element 150, a predetermined gap G1 may be formed between the lower surface of the semiconductor light-emitting element 150 and the first auxiliary electrode 321b of the first assembly wiring 321 and/or the second auxiliary electrode 322b of the second assembly wiring 322. Accordingly, the connecting electrode 370 may be disposed not only around the semiconductor light-emitting element 150 in the assembly hole 340H, but also in the gap region under the lower side of the semiconductor light-emitting element 150. Since the connecting electrode 370 is connected not only to a lateral part but also to a lower side of the electrode 154 of the semiconductor light-emitting element 150, the electrical contact area between the connecting electrode 370 and the semiconductor light-emitting element 150 ca be greatly increased, so that the luminescence efficiency and the light luminance can be significantly improved.

Although not illustrated, instead of the connecting electrode 370, another electrode wiring may be spaced apart from the electrode wiring 360 and connected to a lateral part and a lower side of the semiconductor light-emitting element 150 through the second insulating layer 350.

Meanwhile, the height h1 (or thickness) of the partition wall 340 may be equal to or smaller than the sum of the thickness t2 of the semiconductor light-emitting element 150 and the gap G1. In this instance, the upper surface of the partition wall 340 may be lower than the upper side of the semiconductor light-emitting element 150, so that the semiconductor light-emitting element 150 can be easily assembled into the assembly hole 340H, and a large DEP force may be formed up to the upper side of the assembly hole 340H, so that the semiconductor light-emitting element 150 can be pulled better to increase the assembly rate.

Meanwhile, the display device 300 according to the first embodiment may comprise a second insulating layer 350 and an electrode wiring 360.

The second insulating layer 350 may be disposed on the partition wall 340. The second insulating layer 350 may be disposed on the semiconductor light-emitting element 150. The second insulating layer 350 may be disposed on the connecting electrode 370 disposed in the assembly hole 340H. The second insulating layer 350 may be a flattening layer for easily forming the electrode wiring 360 or another layer. Therefore, an upper surface of the second insulating layer 350 may have a flat straight surface. The first insulating layer 330 and the second insulating layer 350 may be made of an organic material or an inorganic material. For example, at least one or more insulating layer among the first insulating layer 330 and the second insulating layer 350 may be made of an organic material.

The electrode wiring 360 may be disposed on the second insulating layer 350 and electrically connected to the semiconductor light-emitting element 150 through the second insulating layer 350. For example, the electrode wiring 360 may be electrically connected to an upper sides of the light-emitting part 151, 152, and 153 through the second insulating layer 350 and the passivation layer 157 of the semiconductor light-emitting element 150.

Therefore, the semiconductor light-emitting element 150 may emit light by a voltage supplied to the first assembly wiring 321 and/or the second assembly wiring 322 and the electrode wiring 360.

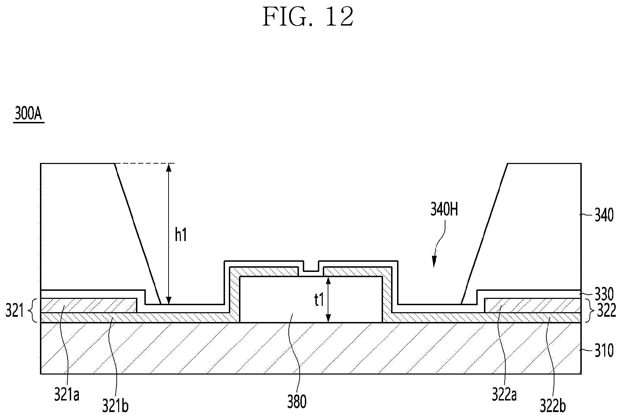

Meanwhile, the display device 300 according to the first embodiment may be manufactured using the backplane substrate 300A illustrated in FIG. 12. The backplane substrate 300A may be a base substrate for manufacturing the display device 300 according to the first embodiment by performing a post-process comprising a self-assembly process and an electrical connection.

That is, by using a self-assembly process and a post-process comprising an electrical connection targeting the backplane substrate 300A, the display device 300 according to the first embodiment may be manufactured.

As illustrated in FIG. 12, a partition wall 340 having a protruding part 380, a first assembly wiring 321 and/or a second assembly wiring 322, an insulating layer 330, and an assembly hole 340H may be formed on the substrate 310, so that the backplane substrate 300A may be manufactured.

First, the protruding part 380 may be formed on the substrate 310. As an insulating film is formed and patterned on the substrate 310, the protruding part 380 may be formed in the assembly hole 340H as an insulating pattern.

Thereafter, the first assembly wiring 321 and the second assembly wiring 322 may be formed. Each of the first assembly wiring 321 and the second assembly wiring 322 may be in contact with the protruding part 380. A part of the first assembly wiring 321, for example, the first auxiliary electrode 321b, and a part of the second assembly wiring 322, for example, the second auxiliary electrode 322b, may be disposed on an upper surface of the protruding part 380. In this instance, the first auxiliary electrode 321b of the first assembly wiring 321 and the second auxiliary electrode 322b of the second assembly wiring 322 may be positioned as high as the thickness t1 of the protruding part 380 by the protruding part 380. Thus, the DEP force on the center of the assembly hole 340H may be greater than the DEP force on the edge of the assembly hole 340H, so that the assembly force of the semiconductor light-emitting element 150 can be strengthened. Accordingly, detachment of the semiconductor light-emitting element 150 assembled in the assembly hole 340H can be prevented, so that assembly defect can be reduced and a lighting rate can be improved.

Thereafter, an insulating layer 330 may be formed on the substrate 310, and an insulating film may be formed and patterned on the insulating layer 330 to form an assembly hole 340H in which the insulating layer 330 is exposed. At this time, a protruding part 380 may be positioned within the assembly hole 340H and may protrude toward an upper direction. A step difference may be formed in the first auxiliary electrode 321b of the first assembly wiring 321 and/or the second auxiliary electrode 322b of the second assembly wiring 322 by the protruding part 380. A step difference may be formed in the insulating layer 330 by the protruding part 380. In addition, since the upper surface of the protruding part 380 is positioned higher than a bottom surface of the assembly hole 340H, a step difference may be formed between the bottom surface of the assembly hole 340H and the first auxiliary electrode 321b of the first assembly wiring 321 and/or the second auxiliary electrode 322b of the second assembly wiring 322, which are disposed on the protruding part 380.

Meanwhile, although not illustrated, a plurality of pixel circuits and a plurality of signal lines connected to each pixel circuit may be provided for each of the plurality of pixels PX on the backplane substrate 300A. The signal lines may comprise the data lines D1 to Dm, the scan lines S1 to Sn, the high-potential voltage line VDDL, the low-potential voltage line VSSL, etc., as illustrated in FIGS. 5 and 6.

Hereinafter, a process for manufacturing a display device 300 according to the first embodiment using the backplane substrate illustrated in FIG. 12 will be described.

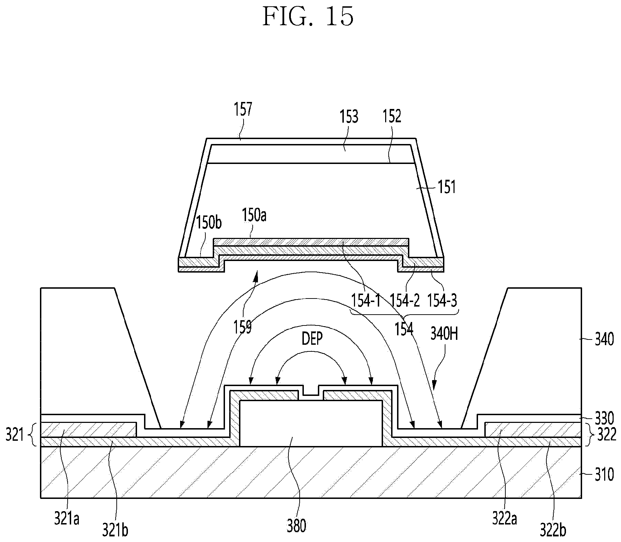

FIGS. 15 to 18 are drawings explaining a manufacturing process of a display device according to the first embodiment.

As illustrated in FIG. 15, a backplane substrate 300A may be provided.

For example, the backplane substrate 300A may be mounted on an upper side of a chamber (1300 of FIG. 9). The semiconductor light-emitting element 150 may be dropped into the fluid 1200 before the backplane substrate 300A is mounted in the chamber 1300 or may be dropped into after the backplane substrate 300A is mounted in the chamber 1300.

Thereafter, an AC voltage may be applied to the first assembly wiring 321 and the second assembly wiring 322 to form a DEP force in the assembly hole 340H. At this time, since the first auxiliary electrode 321b of the first assembly wiring 321 and the second auxiliary electrode 322b of the second assembly wiring 322 are disposed on the upper surface of the protruding part 380, the DEP force formed by the first auxiliary electrode 321b and the second auxiliary electrode 322b on the protruding part 380 may be greater than the DEP force of an edge region of the periphery of the assembly hole 340H.

Thereafter, the semiconductor light-emitting element 150 in the fluid 1200 may be moved along the magnet by the zigzag movement or rotational movement of the magnet. As described above, an area of the second metal layer 154-2 included in the electrode 154 of the semiconductor light-emitting element 150 may be expanded to increase the magnetization force. Thus, the movement speed of the semiconductor light-emitting element 150 toward the magnet may be increased, so that the assembly rate can be improved.

Meanwhile, when the moving semiconductor light-emitting element 150 passes through the assembly hole 340H, it may be assembled into the assembly hole 340H by the DEP force formed in the assembly hole 340H. Since the DEP force on the protruding part 380 is greater than the DEP force in the edge region of the assembly hole 340H, the DEP force formed more significantly in the center region of the assembly hole 340H during self-assembly may exert a strong attractive force on the semiconductor light-emitting element 150, so that the semiconductor light-emitting element 150 can be easily assembled into the assembly hole 340H. In addition, since the DEP force on the protruding part 380 is greater than the DEP force in the edge region of the assembly hole 340H, the fixing force for the semiconductor light-emitting element 150 can be strengthened by the DEP force on the protruding part 380. Thus, the detachment of the assembled semiconductor light-emitting element 150 from the assembly hole 340H can be prevented, so that the assembly defect can be reduced and the lighting rate can be improved.

Meanwhile, when the semiconductor light-emitting element 150 is assembled in the assembly hole 340H and the protruding part 380 is inserted into the recess 159 of the semiconductor light-emitting element 150, the thickness t1 of the protruding part 380 may be greater than the depth d1 of the recess 159 of the semiconductor light-emitting element 150, so that a gap region, i.e., a gap space between the lower side of the semiconductor light-emitting element 150 and the first auxiliary electrode 321b of the first assembly wiring 321 and/or the second auxiliary electrode 322b of the second assembly wiring 322 may be formed. At this time, the gap region may have a gap G1 between the thickness t1 of the protruding part 380 and the depth d1 of the recess 159 of the semiconductor light-emitting element 150.

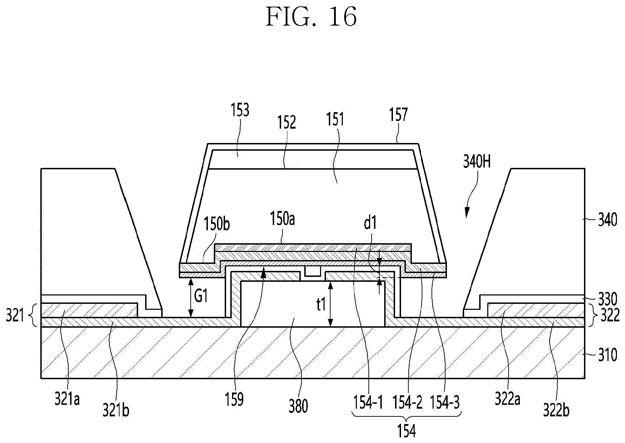

As illustrated in FIG. 16, an etching process may be performed to remove the first insulating layer 330 exposed along the perimeter of the semiconductor light-emitting element 150 within the assembly hole 340H. Accordingly, a part of the first assembly wiring 321, that is, the first auxiliary electrode 321b, and/or a part of the second assembly wiring 322, that is, the second auxiliary electrode 322b, may be exposed along the perimeter of the semiconductor light-emitting element 150 within the assembly hole 340H.

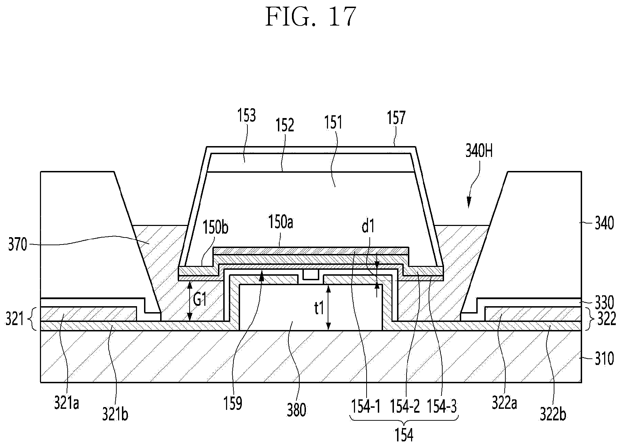

As illustrated in FIG. 17, a metal film may be formed on the partition wall 340 and the semiconductor light-emitting element 150. The metal film may be formed along the perimeter of the semiconductor light-emitting element 150 within the assembly hole 340H.

In an embodiment, the metal film may be formed using an electroplating process. That is, after the plating target, for example, the substrate 310, is immersed in an electrolyte, the first auxiliary electrode 321b of the first assembly wiring 321 and/or the second auxiliary electrode 322b of the second assembly wiring 322 may be connected to a cathode electrode and voltage may be applied, so that a metal film may be coated on the first auxiliary electrode 321b of the first assembly wiring 321 and/or the second auxiliary electrode 322b of the second assembly wiring 322, thereby forming a connecting electrode 370.

As the metal film is coated on the first auxiliary electrode 321b and/or the second auxiliary electrode 322b of the second assembly wiring 322 and gradually becomes thicker, it may be formed along the perimeter of the semiconductor light-emitting element 150 in the assembly hole 340H as well as in the gap region.

By using the electroplating method, the connecting electrode 370 can be firmly connected to the lower side of the semiconductor light-emitting element 150 and the first auxiliary electrode 321b of the first assembly wiring 321 and/or the second auxiliary electrode 322b of the second assembly wiring 322 through the gap region, so that the fixing force of the semiconductor light-emitting element 150 can be strengthened. In addition, since the connecting electrode 370 is in contact not only with a lower side of the semiconductor light-emitting element 150 but also with a lateral part of the semiconductor light-emitting element 150, the electrical contact area between the connecting electrode 370 and the semiconductor light-emitting element 150 can be expanded, so that the luminescence efficiency and the light luminance can be significantly improved.

Meanwhile, when it is difficult to increase the film thickness during the electroplating process, the connecting electrode 370 may be formed only in the region under the lower side of the semiconductor light-emitting element 150, i.e., the gap region, and may not be formed on a lateral part of the semiconductor light-emitting element 150. Even if the connecting electrode 370 is formed only in the gap region, a sufficient electrical contact area may be secured to facilitate current flow. In addition, even if the connecting electrode 370 is formed only in the gap region, since the connecting electrode 370 is formed in the gap region, which is the shortest space between the lower side of the semiconductor light-emitting element 150 and the first auxiliary electrode 321b of the first assembly wiring 321 and/or the second auxiliary electrode 322b of the second assembly wiring 322, the current loss can be reduced by minimizing the current path, thereby improving the luminescence efficiency and light luminance.

As another example, a metal film may be formed and patterned on the substrate 310 using a deposition process, and formed along the perimeter of the semiconductor light-emitting element 150 in the assembly hole 340H.

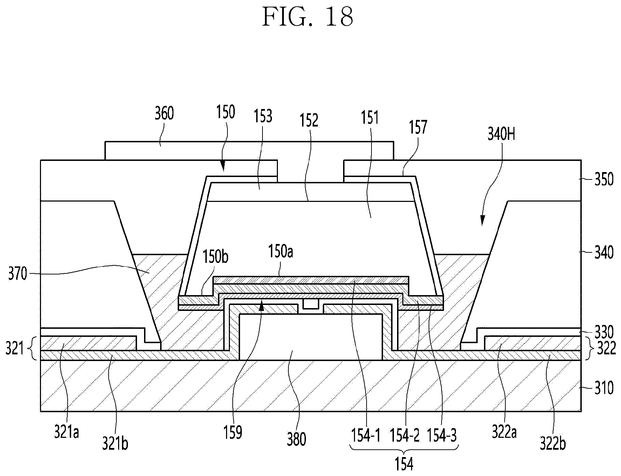

As illustrated in FIG. 18, a second insulating layer 350 may be formed on an entire region of the substrate 310, such as the partition wall 340, the connecting electrode 370, and the semiconductor light-emitting element 150, and the second insulating layer 350 and the passivation layer 157 of the semiconductor light-emitting element 150 are removed to form a contact hole.

Thereafter, an electrode wiring 360 may be formed on the second insulating layer 350, so that the electrode wiring 360 may be electrically connected to the upper side of the semiconductor light-emitting element 150 through the contact hole.

### [Second embodiment]

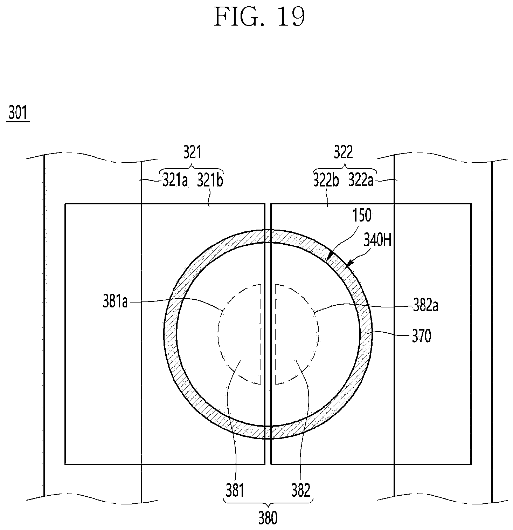

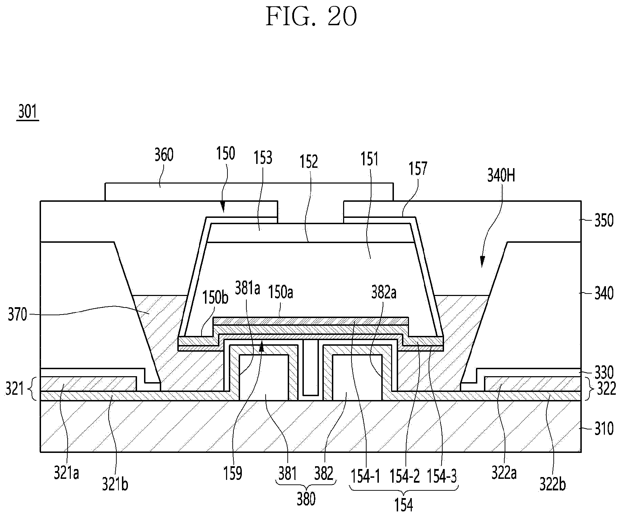

FIG. 19 is a plan view illustrating a display device according to a second embodiment. FIG. 20 is a cross-sectional view illustrating a display device according to the second embodiment.

The second embodiment is the same as the first embodiment except that the protruding part 380 is separated into a first protruding region 381 and a second protruding region 382 by a metal pattern. In the second embodiment, components having the same shape, structure, and/or function as those of the first embodiment are given the same drawing reference numerals and detailed descriptions are omitted.

Referring to FIG. 19 and FIG. 20, the display device 301 according to the second embodiment may comprise a substrate 310, a first assembly wiring 321, a second assembly wiring 322, a partition wall 340, a protruding part 380, a first insulating layer 330, a semiconductor light-emitting element 150, and a connecting electrode 370. In addition, the display device 301 according to the second embodiment may comprise a second insulating layer 350 and an electrode wiring 360.

The protruding part 380 may be disposed in the assembly hole 340H. The protruding part 380 may be disposed at the center of the assembly hole 340H.

The protruding part 380 may be disposed on the substrate 310. The protruding part 380 may be in contact with the upper surface of the substrate 310, but is not limited thereto.

The protruding part 380 may be a metal pattern. That is, the protruding part 380 may be made of metal. The protruding part 380 may have a multilayer structure. When the semiconductor light-emitting element 150 is assembled into the assembly hole 340H and the protruding part 380 is inserted into the recess 159 of the semiconductor light-emitting element 150, the protruding part 380 may have a sufficient thickness t1 so that the lower side of the semiconductor light-emitting element 150 may be spaced apart from the first assembly wiring 321 and/or the second assembly wiring 322.

The protruding part 380 may be electrically connected to the first assembly wiring 321 and/or the second assembly wiring 322. In this instance, the first assembly wiring 321 and the second assembly wiring 322 may be electrically short-circuited via the protruding part 380.

To solve this problem, in the embodiment, the protruding part 380 may comprise a first protruding region 381 and a second protruding region 382 that are spatially spaced from each other. The first protruding region 381 and the second protruding region 382 may be horizontally spaced apart from each other, but are not limited thereto. In this instance, the first assembly wiring 321 may be electrically connected to the first protruding region 381, and the second assembly wiring 322 may be electrically connected to the second protruding region 382. At this time, since the first protruding region 381 and the second protruding region 382 are spatially spaced from each other, the first assembly wiring 321 and the second assembly wiring 322 may be electrically insulated.

For example, the first auxiliary electrode 321b of the first assembly wiring 321 may be in contact with the first protruding region 381. For example, the first auxiliary electrode 321b of the first assembly wiring 321 may be in contact with a first outer side 381a of the first protruding region 381 and/or the upper surface of the first protruding region 381. For example, the first auxiliary electrode 321b of the first assembly wiring 321 may surround the first outer side 381a of the first protruding region 381. For example, the second auxiliary electrode 322b of the second assembly wiring 322 may be in contact with a second outer side 382a of the second protruding region 382 and the upper surface of the second protruding region 382. For example, the second auxiliary electrode 322b of the second assembly wiring 322 may surround the second outer side 382a of the second protruding region 382.

Meanwhile, as illustrated in FIG. 13 and FIG. 20, a first protruding region 381 and a second protruding region 382 may be inserted into the recess 159 of the semiconductor light-emitting element 150. In this instance, a first outer side 381a of the first protruding region 381 may have a shape corresponding to the shape of a first inner side 150c of the recess 159. A second outer side 382a of the second protruding region 382 may have a shape corresponding to the shape of a second inner side 150d of the recess 159.

Meanwhile, a step difference may be generated in the first auxiliary electrode 321b of the first assembly wiring 321 by the first protruding region 381, and a step difference may be generated in the second auxiliary electrode 322b of the second assembly wiring 322 by the second protruding region 382. That is, the first auxiliary electrode 321b of the first assembly wiring 321 disposed on the upper surface of the first protruding region 381 and the second auxiliary electrode 322b of the second assembly wiring 322 disposed on the second protruding region 382 may be positioned higher than the first auxiliary electrode 321b of the first assembly wiring 321 disposed on the edge region of the assembly hole 340H and the second auxiliary electrode 322b of the second assembly wiring 322 disposed on the second protruding region 382.

When a DEP force is formed in the assembly hole 340H by the first assembly wiring 321 and the second assembly wiring 322, the intensity of the DEP force at the center of the assembly hole 340H, that is, on the first protruding region 381 and the second protruding region 382, may be greater than the DEP force on the edge region of the assembly hole 340H. Accordingly, the semiconductor light-emitting element 150 can be more easily inserted into the assembly hole 340H during self-assembly, and the semiconductor light-emitting element 150 assembled in the assembly hole 340H can be more strongly fixed to prevent the semiconductor light-emitting element 150 from falling out of the assembly hole 340H.

Meanwhile, due to the thick thickness of each of the first protruding region 381 and the second protruding region 382, when the first protruding region 381 and the second protruding region 382 are inserted into the recess 159 of the semiconductor light-emitting element 150, a gap region may be formed in a space where the lower side of the semiconductor light-emitting element 150 is spaced apart from the first auxiliary electrode 321b of the first assembly wiring 321 and/or the second auxiliary electrode 322b of the second assembly wiring 322. The connecting electrode 370 may be disposed in the corresponding gap region, and may also be disposed along the perimeter of the semiconductor light-emitting element 150 in the assembly hole 340H. Therefore, the connecting electrode 370 contacts not only a lateral part but also a lower side of the electrode 154 of the semiconductor light-emitting element 150, so that the electrical contact area can be expanded to improve the luminescence efficiency and the light luminance.

The first insulating layer 330, the second insulating layer 350, and the electrode wiring 360 have been described in the first embodiment, so further description is omitted.

### [Third embodiment]

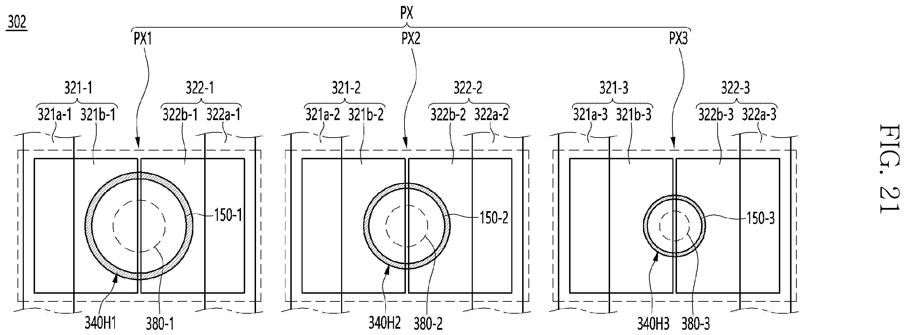

FIG. 21 is a plan view illustrating a display device according to a third embodiment. FIG. 22 is a cross-sectional view illustrating a display device according to the third embodiment.

The third embodiment is the same as the first embodiment or the second embodiment except for the first subpixel PX1, the second subpixel PX2, and the third subpixel XP3 constituting the unit pixel PX. That is, the subpixel described in the first embodiment or the second embodiment may be one of the first subpixel PX1, the second subpixel PX2, and the third subpixel XP3 to be described in the third embodiment.

In the third embodiment, components having the same shape, structure, and/or function as those in the first embodiment or the second embodiment are given the same drawing reference numerals and detailed descriptions are omitted.

Referring to FIGS. 21 and 22, the display device 302 according to the third embodiment comprises a plurality of pixels PX, and each of the plurality of pixels PX may comprise a first subpixel PX1, a second subpixel PX2, and a third subpixel XP3. For example, the first subpixel PX1 may output red light, the second subpixel PX2 may output green light, and the third subpixel XP3 may output blue light.

To this end, the first subpixel PX1, the second subpixel PX2, and the third subpixel XP3 may comprise a substrate 310, first assembly wirings 321-1, 321-2, and 321-3, second assembly wirings 322-1, 322-2, and 322-3, a partition wall 340, a protruding part 380, a first insulating layer 330, semiconductor light-emitting elements 150-1, 150-2, and 150-3, and connecting electrodes 370, 370-1, 370-2, and 370-3. In addition, the first subpixel PX1, the second subpixel PX2, and the third subpixel XP3 may each comprise a second insulating layer 350 and electrode wirings 360-1, 360-2, and 360-3.

In the third embodiment, a first semiconductor light-emitting element 150-1, a second semiconductor light-emitting element 150-2, and a third semiconductor light-emitting element 150-3 may have different sizes.

As an example, widths (or lengths) of a first recess 159-1 of the first semiconductor light-emitting element 150-1, a second recess 159-2 of the second semiconductor light-emitting element 150-2, and a third recess 159-3 of the third semiconductor light-emitting element 150-3 may be different. For example, the width of the first recess 159-1 may be greater than the width of the second recess 159-2, and the width of the second recess 159-2 may be greater than the width of the third recess 159-3. The width of the first recess 159-1 may be smaller than a width of an upper side of the second semiconductor light-emitting element 150-2, and the width of the second recess 159-2 may be smaller than a width of the upper side of the third semiconductor light-emitting element 150-3. Accordingly, even if the first semiconductor light-emitting element 150-1, the second semiconductor light-emitting element 150-2, and the third semiconductor light-emitting element 150-3 are assembled simultaneously by the same self-assembly process, the phenomenon in which a specific semiconductor light-emitting element is inserted into the recess of another semiconductor light-emitting element and clumps together can be prevented. At this time, the width of the third recess 159-3 of the third semiconductor light-emitting element 150-3 may be smaller than a value obtained by subtracting 2 micrometers from the width of the lower side of the third semiconductor light-emitting element 150-3, but is not limited thereto.

As another example, the depths d11, d12 and d13 of the first recess 159-1 of the first semiconductor light-emitting element 150-1, the second recess 159-2 of the second semiconductor light-emitting element 150-2 and the third recess 159-3 of the third semiconductor light-emitting element 150-3 may be different from each other. For example, the depth d11 of the first recess 159-1 may be greater than the depth d12 of the second recess 159-2, and the depth d12 of the second recess 159-2 may be greater than the depth d13 of the third recess 159-3. At this time, the depth d12 of the first recess 159-1 may be at least three times the depth d13 of the third semiconductor light-emitting element 150-3, the depth d12 of the second recess 159-2 may be at least twice the depth d13 of the third semiconductor light-emitting element 150-3, and the depth d13 of the third semiconductor light-emitting element 150-3 may be at least 300 nanometers or more, but is not limited thereto.

The width of the first recess 159-1 may be smaller than the width of the upper side of the second semiconductor light-emitting element 150-2, and the width of the second recess 159-2 may be smaller than the width of the upper side of the third semiconductor light-emitting element 150-3. Accordingly, even if the first semiconductor light-emitting element 150-1, the second semiconductor light-emitting element 150-2, and the third semiconductor light-emitting element 150-3 are assembled simultaneously by the same self-assembly process, the phenomenon in which a specific semiconductor light-emitting element is inserted into the recess of another semiconductor light-emitting element and clumps together can be prevented. At this time, the width of the third recess 159-3 of the third semiconductor light-emitting element 150-3 may be smaller than a value obtained by subtracting 2 micrometers from the width of the lower side of the third semiconductor light-emitting element 150-3, but is not limited thereto.

In this way, by making the widths or depths d11, d12 and d13 of the first recess 159-1 of the first semiconductor light-emitting element 150-1, the second recess 159-2 of the second semiconductor light-emitting element 150-2 and the third recess 159-3 of the third semiconductor light-emitting element 150-3 different, the exclusivity can be strengthened, so that the first semiconductor light-emitting element 150-1, the second semiconductor light-emitting element 150-2 and the third semiconductor light-emitting element 150-3 can be assembled simultaneously, thereby drastically increasing the assembly speed and improving productivity.

Meanwhile, the sizes of the protruding parts 380-1, 380-2 and 380-3 of the first subpixel PX1, the second subpixel PX2 and the third subpixel XP3 may be different, but may also be the same.

For example, the width of the first protruding part 380-1 on the first subpixel PX1 may be greater than the width of the second protruding part 380-2 on the second subpixel PX2, and the width of the second protruding part 380-2 on the second subpixel PX2 may be greater than the width of the third protruding part 380-3 on the third subpixel XP3.

For example, the thickness t11 of the first protruding part 380-1 on the first subpixel PX1 may be greater than the thickness t12 of the second protruding part 380-2 on the second subpixel PX2, and the thickness t12 of the second protruding part 380-2 on the second subpixel PX2 may be greater than the thickness t13 of the third protruding part 380-3 on the third subpixel XP3. When the sizes of the protruding parts 380-1, 380-2, and 380-3 of the first subpixel PX1, the second subpixel PX2, and the third subpixel XP3 are different, the first gap G11 of the first subpixel PX1, the second gap G12 of the second subpixel PX2, and the third gap G13 of the third subpixel XP3 may also be different. For example, the first gap G11 of the first subpixel PX1 may be greater than the second gap G12 of the second subpixel PX2, and the second gap G12 of the second subpixel PX2 may be greater than the third gap G13 of the third subpixel XP3.

For example, the thickness t11 of the first protruding part 380-1 on the first subpixel PX1, the thickness t12 of the second protruding part 380-2 on the second subpixel PX2, and the thickness t13 of the third protruding part 380-3 on the third subpixel XP3 may be the same. In this instance, the first gap G11 of the first subpixel PX1, the second gap G12 of the second subpixel PX2, and the third gap G13 of the third subpixel XP3 may be different. For example, the first gap G11 of the first subpixel PX1 may be greater than the second gap G12 of the second subpixel PX2, and the second gap G12 of the second subpixel PX2 may be greater than the third gap G13 of the third subpixel XP3. In contrast, the first gap G11 of the first subpixel PX1, the second gap G12 of the second subpixel PX2, and the third gap G13 of the third subpixel XP3 may be the same.

According to the third embodiment, by making the widths or depths d11, d12, and d13 of the recesses of the semiconductor light-emitting devices 150-1, 150-2, and 150-3 on the first subpixel PX1, the second subpixel PX2, and the third subpixel XP3 different to enhance exclusivity, the first semiconductor light-emitting element 150-1, the second semiconductor light-emitting element 150-2, and the third semiconductor light-emitting element 150-3 can be assembled simultaneously. Accordingly, the assembly speed can be drastically increased to improve productivity.

According to the third embodiment, the first semiconductor light-emitting element 150-1, the second semiconductor light-emitting element 150-2, and the third semiconductor light-emitting element 150-3 may have the same shape, for example, a circular shape, while the width or depth d11, d12, and d13 of the recess are different, so that the assembly rate and assembly speed can be improved, chip detachment can be minimized, assembly defects can be reduced, and the lighting rate can be improved.

Meanwhile, the display device described above may be a display panel. That is, in the embodiment, the display device and the display panel may be understood to have the same meaning. In the embodiment, the display device in a practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using semiconductor light-emitting elements. The semiconductor light-emitting element may be a micro-level semiconductor light-emitting element or a nano-level semiconductor light-emitting element.

For example, the embodiment may be adopted in a TV, signage, a mobile terminal such as a mobile phone or a smart phone, display for computer such as a laptop or a desktop, a head-up display (HUD) for an automobile, a backlight unit for display, display for VR, AR or mixed reality (MR), a light source, etc.

## Claims

1. A display device, comprising:
a substrate;
a first assembly wiring and a second assembly wiring on the substrate;
a partition wall having an assembly hole on the first assembly wiring and the second assembly wiring;
a protruding part in the assembly hole;
a semiconductor light-emitting element having a recess and seated on the protruding part; and
a connecting electrode on a lower side of the semiconductor light-emitting element.

2. The display device of claim 1, wherein the protruding part is an insulating pattern.

3. The display device of claim 2, wherein the protruding part has a shape corresponding to a shape of the recess.

4. The display device of claim 1, wherein the protruding part is a metal pattern.

5. The display device of claim 4, wherein the protruding part comprises a first protruding region and a second protruding region that are horizontally spaced from each other.

6. The display device of claim 5, wherein a first outer side of the first protruding region has a shape corresponding to a shape of a first inner side of the recess, and
wherein a second outer side of the second protruding region has a shape corresponding to a shape of a second inner side of the recess.

7. The display device of claim 1, wherein a thickness of the protruding part is greater than a depth of the recess.

8. The display device of claim 7, wherein the connecting electrode is disposed in a gap region between the thickness of the protruding part and the depth of the recess.

9. The display device of claim 8, wherein a height of the partition wall is equal to or smaller than a sum of a thickness of the semiconductor light-emitting element and the gap.

10. In claim 1, wherein the semiconductor light-emitting element comprises:
a light-emitting layer;
an electrode under the light-emitting layer; and
a passivation layer configured to surround the light-emitting layer.

11. The display device of claim 10, wherein a lower surface of the light-emitting layer has a first region and a second region configured to surround the first region, and
wherein the recess is formed in the first region of the light-emitting layer.

12. The display device of claim 11, wherein the electrode comprises:
a first metal layer on the lower surface of the light-emitting layer;
a second metal layer under the first metal layer; and
a third metal layer under the second metal layer,
wherein the first metal layer is in contact with the first region of the light-emitting layer, and
wherein the second metal layer is in contact with the second region of the light-emitting layer and the first metal layer.

13. The display device of claim 12, wherein an electrical resistance of the second metal layer is smaller than an electrical resistance of the first metal layer.

14. The display device of claim 12, wherein the first metal layer comprises a reflective layer,
wherein the second metal layer comprises an ohmic contact layer, and
wherein the third metal layer comprises a magnetic layer.

15. The display device of claim 1, wherein the substrate comprises a plurality of pixels, and
wherein each of the plurality of pixels comprise a first subpixel, a second subpixel, and a third subpixel,
wherein the semiconductor light-emitting element comprises a first semiconductor light-emitting element on the first subpixel, a second semiconductor light-emitting element on the second subpixel, and a third semiconductor light-emitting element on the third subpixel, and
wherein sizes of the first semiconductor light-emitting element, the second semiconductor light-emitting element, and the third semiconductor light-emitting element are different.

16. The display device of claim 15, wherein the recess has a first recess on a lower side of the first semiconductor light-emitting element, a second recess on a lower side of the second semiconductor light-emitting element, and a third recess on a lower side of the third semiconductor light-emitting element, and
wherein sizes of the first recess, the second recess, and the third recess are different.

17. The display device of claim 16, wherein the protruding part comprises:
a first protruding part in the first assembly hole on the first subpixel;
a second protruding part in the second assembly hole on the second subpixel; and
a third protruding part in the third assembly hole on the third subpixel, and
wherein sizes of the first protruding part, the second protruding part, and the third protruding part are different.

18. The display device of claim 17, wherein the connecting electrode comprises:
a first connecting electrode in a first gap region between a thickness of the first protruding part and a depth of the first recess;
a second connecting electrode in a second gap region between a thickness of the second protruding part and a depth of the second recess; and
a third connecting electrode in a third gap region between a thickness of the third protruding part and a depth of the third recess.
